# EUROPEAN PATENT APPLICATION

(11) **EP 0 563 629 A1**
(43) Date of publication of application: **06.10.1993**
(21) Application number: 93103703.0
(22) Date of filing: 08.03.1993
(51) Int. Cl.: H05K 13/00

(54) **Integrated circuit shipping medium**

(30) Priority: 31.03.1992 US 860870
(71) Applicant: MOTOROLA, INC., Schaumburg, IL 60196 (US)
(72) Inventor: Gerke, Robert David, Austin, Texas 78729 (US); Stover, Mary Moore, Austin, Texas 78750 (US)
(74) Representative: Hudson, Peter David

(57) **Abstract**

Plastic encapsulated ICs (20) are susceptible to moisture due to the permeability of molding compounds. ICs (20) may be baked until dry before being shipped to the customer to reduce the risk of cracking. To retain this dry condition, ICs (20) are packaged and shipped in dry-packs. A desiccating layer (12) is provided for tape and reel IC shipping medium (10) to protect ICs from moisture. The desiccating layer (12) extends the length of the carrier tape (16) providing an equal level of protection for each of the IC (20) contained inside pockets (18) of carrier tape (16). Each IC (20) remains protected by desiccant (12) until the IC (20) is removed from pocket (18) immediately before being mounted onto a printed circuit board. Individualized desiccant protection can also be applied to other IC shipping media such as rails and trays.

## Description

### Field of the Invention

The present invention relates to the packaging for shipping of integrated circuits in general, and more specifically to desiccants that are included with each batch shipment of ICs.

### Background of the Invention

Plastic encapsulated semiconductor devices are susceptible to moisture ingress due to the permeable nature of plastic molding compounds. The amount of moisture that a plastic IC absorbs from its environment is dependent on several factors: the length of exposure time to the environment, the diffusivity of the plastic or how quickly moisture can be absorbed into the material, the solubility coefficient of the plastic or its saturation capacity, and the thickness of the plastic body on the IC. Devices containing moisture levels exceeding some critical amount run the risk of cracking or "popcorning" during the rapid heating of the solder reflow operation. Semiconductor devices which are subject to cracking are normally baked in an oven at approximately 125°C, a typical temperature, for a predetermined length of time to drive moisture out of the devices before they are shipped to the customer. Those devices that are deemed to be moisture sensitive are packaged in "dry-packs" after baking to ensure that they are protected from moisture thereafter and will arrive in a safe condition, that is not moisture laden, at the customer site. Otherwise, devices that have absorbed a certain level of moisture run the risk of cracking during the solder reflow operation. Mechanical failure of the ICs often times lead to subsequent electrical failure of these same devices due to thermal and mechanical stresses induced on the ICs during their operation.

Current dry-packing practices involve baking parts until dry, placing them into a dry-pack bag with desiccant packets and a humidity indicator card, vacuum sealing the bag immediately thereafter, and shipping the devices to the customer in these dry-packs. The amount of desiccant in each dry-pack bag can be determined by using IPC Standard SM786. A problem with the current method of dry-packing is that desiccant packets may not keep the dry-pack bag uniformly dry, because a desiccant packet is most effective for a small region surrounding it. Therefore, the location of the semiconductor devices relative to the desiccant also affects the amount of moisture that will be absorbed by the desiccant away from the devices. Those devices closer to the desiccant benefit more from the desiccant than those devices that are farther away from the desiccant. Furthermore, the desiccant packets are only placed in the dry-pack bag, but not directly in the IC shipping medium, such as tape and reel or rails or trays. The shipping medium itself can serve as a deterrent to the efficacy of the desiccant by being a physical barrier between the semiconductor devices and the desiccant packets.

Another limitation of current dry-packing is that once the dry-pack bag has been opened, all moisture protection is lost. The ICs along with their shipping medium become exposed to the environmental conditions of the end-user's shop or storage warehouse, thus imposing a time constraint on the user: that is, the end-user has only a limited amount of time to surface mount the semiconductor devices to the printed circuit (PC) board and still be guaranteed a low enough level of moisture absorption in the devices to avoid their cracking during the solder reflow operation. A more controlled environment with low humidity will allow the user more time to surface mount the devices to his PC boards than an uncontrolled environment with high humidity. However, the time constraint problem exists in either case.

### Summary of the Invention

In accordance with the invention, there is provided an integrated circuit (IC) packaging medium having a shipping means for carrying ICs, a cover, and a desiccant. The shipping means for carrying ICs has at least one compartment wherein the ICs are contained. The cover contains the ICs within the shipping means. The desiccant is placed in close proximity to the ICs contained inside the compartment of the shipping means and is located between the shipping means and the cover wherein the desiccant is individualized for each of the ICs. These and other features, and advantages, will be more clearly understood from the following detailed description taken in conjunction with the accompanying drawings. It is important to point out that the illustrations may not necessarily be drawn to scale, and that there may be other embodiments of the present invention which are not specifically illustrated.

### Brief Description of the Drawings

FIG. 1 is a top view of a portion of a tape and reel IC shipping medium with a continuous desiccant layer under a cover tape, illustrating an embodiment of the present invention.

FIG. 2 is a cross-sectional view of FIG. 1 showing a cross-section of the portion of tape and reel IC shipping medium with the desiccant layer between the cover tape and the carrier tape.

FIG. 3 is a top view of a portion of a tape and reel shipping IC medium with discrete desiccants under a cover tape, illustrating a second embodiment of the present invention.

FIG. 4 is a cross-sectional view of FIG. 3 showing a cross-section of the portion of tape and reel IC shipping medium with the discrete desiccants between the cover tape and the carrier tape.

FIG. 5 is cross-sectional view of a portion of tape and reel IC shipping medium with individualized desiccants inside each compartment of the carrier tape, illustrating a third embodiment of the invention.

FIG. 6 is a top view of a rail for carrying ICs with a continuous layer of desiccant inside the rail, illustrating a fourth embodiment of the invention.

FIG. 7 is a cross-sectional view of FIG. 6 showing a cross-section of the rail with the desiccant layer between the IC and the rail window.

FIG. 8 is cross-sectional view of a portion of tape and reel IC shipping medium with a continuous strip of humidity sensing indicators between the cover tape and carrier tape and individualized desiccants inside each pocket of the carrier tape, illustrating a fifth embodiment of the invention.

FIG. 9 is cross-sectional view of a rail for carrying ICs with a continuous strip of humidity sensing indicators between the IC and the rail window and a continuous layer of desiccant in the bottom of the rail, illustrating a sixth embodiment of the invention.

### Detailed Description of a Preferred Embodiment

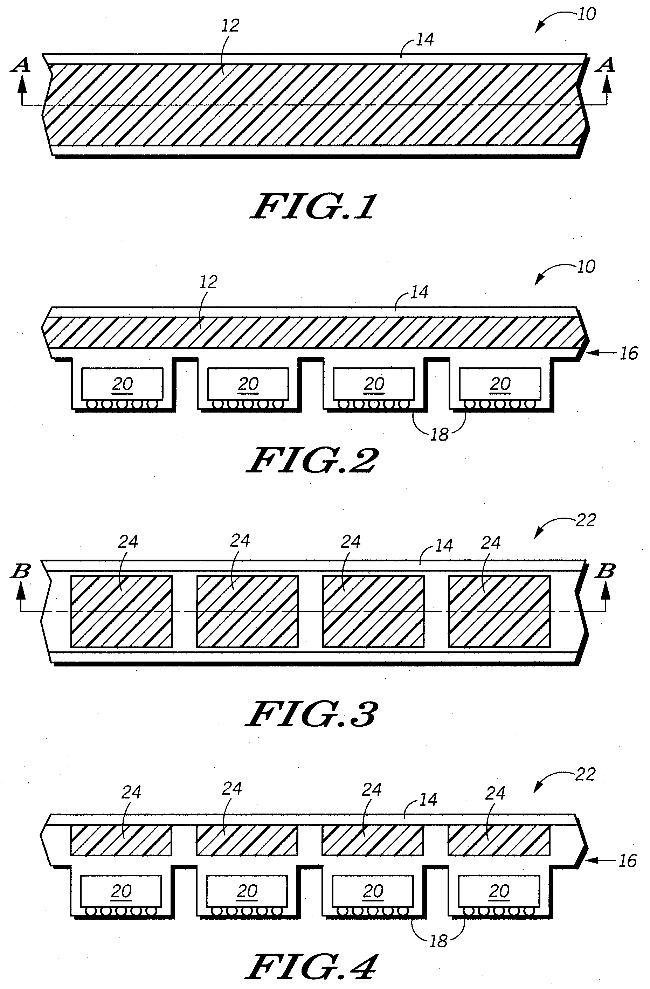

With the present invention, it is possible to meet the previously stated desired feature of uniformly protecting semiconductor devices from moisture ingress. The invention enables individualized desiccants for each semiconductor device to be incorporated into an IC packaging medium. Moreover, the invention provides a method for manufacturing an IC packaging medium with individualized desiccants. In accordance with the invention, shown in FIG. 1 is a portion 10 of a tape and reel IC shipping medium with a continuous desiccant layer 12 under a cover tape 14, illustrating an embodiment of the present invention. The desiccant layer 12 can be formed from a polyvinyl alcohol, a polyvinyl ethylene acetate copolymer, a methyl cellulose, a water soluble polymer, a silica gel, or any other material in a class of organic, inorganic or a composite thereof, that can act as a humectant. Hence, desiccant layer 12 can comprise several materials, either as multiple layers or as a composite of one or several materials dispersed in another. It is important to select a desiccant that does not act as a contaminant to the ICs, such as having inadequate ESD (electrostatic discharge) protection or changing physical and chemical characteristics with the absorption of water. Furthermore, it is also necessary to choose a desiccating material that will absorb moisture at a faster rate than the plastic encapsulated semiconductor devices. The thickness of the desiccant layer 12 can be substantially in a range from 0.05 millimeter to 0.64 millmeter depending on the type of material chosen as a desiccant.

A cross-sectional view of FIG. 1 showing the portion 10 of tape and reel IC shipping medium with the desiccant layer 12 between the cover tape 14 and the carrier tape 16 is illustrated in FIG. 2, an embodiment of the invention. Carrier tape 16 has a plurality of individualized compartments 18 for carrying ICs. Semiconductor devices 20, illustrated in FIG. 2 as plastic pad array carriers, are shown inside the compartments 18. Because desiccant layer 12 extends the length of the cover tape 14 and carrier tape 16, each device 20 has the same amount of protection from moisture from the desiccant 12.

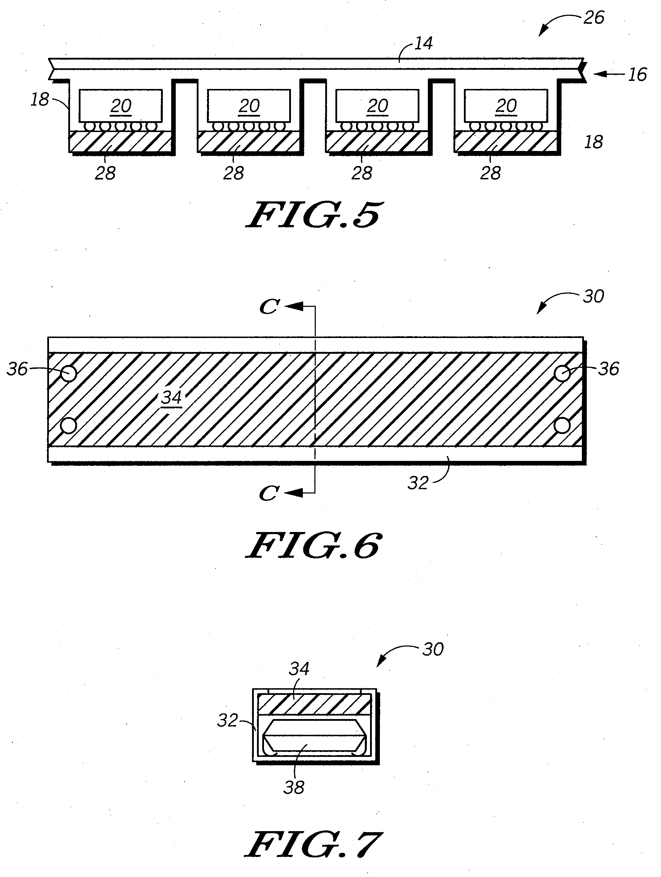

A second embodiment of the invention is illustrated in FIG. 3 showing a portion 22 of a tape and real IC shipping medium with discrete desiccants 24 under a cover tape 14. The class of materials for discrete desiccants 24 is the same as that of desiccant layer 12, shown in FIG. 1. The thickness of the desiccant can also be in the same range of 0.05 millimeter to 0.64 millimeter depending on the material used. Illustrated in FIG. 4 is a cross-sectional view of the second embodiment showing the portion 22 of tape and real IC shipping medium wherein the discrete desiccants 24 are located between the cover tape 14 and carrier tape 16. The discrete desiccants 24 are positioned directly over the plurality of compartments 18 with a one to one corresponding ratio thereof. This configuration allows equal protection from moisture for each semiconductor device 20 contained inside compartments 18.

Shown in FIG. 5 is a cross-section of a portion 26 of a tape and real IC shipping medium with discrete desiccants 28 located inside the plurality of compartments 18 of carrier tape 16, illustrating a third embodiment of the present invention. This third configuration provides each compartment 18 with discrete desiccants 28 thereby allowing individual moisture protection for the devices 20. The class of materials for discrete desiccants 28 is the same as that of desiccant layer 12, shown in FIG. 1. The thickness of the desiccant can also be in the same range of 0.05 millimeter to 0.64 millimeter depending on the material used.

In addition to tape and real IC shipping medium, the concept of discrete desiccants can be applied to a shipping tray also. The discrete desiccants can be located either inside each tray pocket or on the underside of the tray. Semiconductor devices shipped in trays typically have another tray or trays filled with devices stacked on top of each other, the top tray being empty and used as a lid. Therefore either option provides each semiconductor device carried in the pockets of a tray with an individualized desiccant. Another option to providing desiccant protection for each IC in a tray is to use a sheet of desiccant which can be placed between the stacking trays.

Yet another alternative embodiment to the invention is illustrated in FIG. 6. Shown is an IC shipping medium 30 comprising a shipping rail or tube 32, a desiccant layer 34, and a plurality of stoppers 36. The desiccant layer 34 is continuous and extends the length of shipping rail 32, thereby providing continuous coverage for the semiconductor devices, not shown, to equally protect each device from moisture ingress. Stoppers 36 contain the devices inside the shipping rail 32. A cross-sectional view of this fourth embodiment is shown in FIG. 7. Desiccant layer 34 is located inside the top of shipping rail 32. A representative J-leaded semiconductor device 38 is shown, although other package configurations such as quad flat packs and dual-in-line packages can also be shipped in rails. Again, the class of materials for desiccant layer 34 is the same as that of desiccant layer 12, shown in FIG. 1. The thickness of the desiccant can also be in the same range of 0.05 millimeter to 0.64 millimeter depending on the material used.

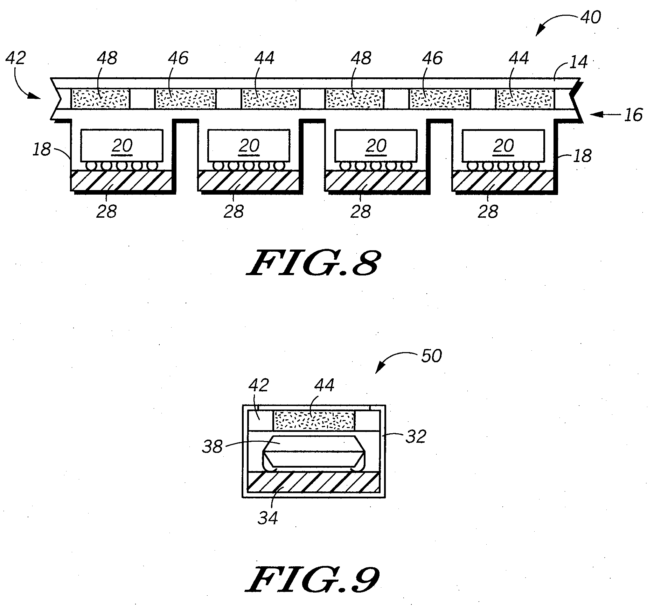

Another embodiment of the present invention combines both individualized desiccants with compartmentalized humidity sensing indicators. As illustrated in FIG. 8, a portion 40 of a tape and real IC shipping medium comprises a cover tape 14, a carrier tape 16 with a plurality of compartments 18 containing semiconductor devices 20, discrete desiccants 28, and a strip 42 with a repeating series of humidity sensing indicators 44, 46, and 48. Strip 42 extends for the length of cover tape 14 and carrier tape 16, and the width is cut to match the width of carrier tape 16 and cover tape 14. This fifth configuration provides each compartment 18 with discrete desiccants 28 thereby allowing individual moisture protection for the devices 20 in addition to localized monitoring of moisture levels for the devices 20. The class of materials for discrete desiccants 28 is the same as that of desiccant layer 12, shown in FIG. 1. The thickness of the desiccant can also be in the same range of 0.05 millimeter to 0.64 millimeter depending on the material used.

Humidity sensing indicator 44, typically blue in color, changes to a pink color when it senses a relative humidity of 20% or greater. Manufacturers normally guarantee a maximum relative humidity of 30% for dry-pack conditions, which is typically considered a safe moisture level for board mounting of most plastic encapsulated semiconductor devices. Therefore, humidity sensing indicator 46 changes to a pink color when it senses a relative humidity of 30% or greater. Indicator 46 tells the user to exercise caution when this condition exists and that the user's guide need to be consulted before surface mounting of the plastic encapsulated ICs. When relative humidity conditions reach or exceed 40%, humidity sensing indicator 48 changes to a pink color. Indicator 48, when activated, tells the user to rebake the plastic encapsulated semiconductor devices before surface mounting.

As illustrated in FIG. 8, the humidity sensing indicators 44, 46 and 48 are sized and spaced such that every two compartments 18 are covered by a series of indicators 44, 46, and 48. The advantage to having only two compartments per series of indicators is the localized measurement of relative humidity. Therefore, an accurate moisture exposure history is recorded for each IC, thus allowing a selective rebaking of parts. In effect rebake before mounting of all parts can be reduced to rebake of only those parts that have had excessive exposure to moisture. In practice, the number of compartments covered by a series of indicators can vary per application. For example, if the compartments are large, then each compartment can be covered by a series of indicators; or conversely, if the compartments are small, then more than two compartments can be covered by a series of indicators. The advantage to this fifth embodiment is the individual moisture protection for the semiconductor devices 20 in addition to localized monitoring of moisture levels for the devices 20.

Yet another embodiment of the present invention combining both a continuous layer of desiccant with localized humidity sensing indicators is possible. Illustrated in FIG. 9 is a cross-sectional view of IC shipping medium 50. Shown is a shipping rail or tube 32, a desiccant layer 34, a strip 42 of humidity sensing indicators, and a semiconductor device 38. The desiccant layer 34 is continuous and extends the length of shipping rail 32, thereby providing continuous coverage for the semiconductor devices 38, to equally protect each device from moisture ingress. Strip 42 has a repeating series of humidity sensing indicators as previously shown in FIG. 8.

Also in accordance with the present invention is a method for incorporating individualized desiccants into an IC packaging medium to uniformly protect semiconductor devices from moisture ingress. Carrier tapes of tape and real IC packaging medium have individual pockets or compartments to carry semiconductor devices. Preforms of a hygroscopic material, such as partially hydrolyzed polyvinyl alcohol, can be made according to the size of the carrier tape compartments. Since this material is a thermoplastic, it can be spot tacked into place. An alternative method is to dispense a liquid form of a hygroscopic material into the compartments of the carrier tape and then curing the material. Semiconductor devices can then be loaded into the compartments of the carrier tape and sealed with a cover tape for shipping. Such an embodiment is shown in FIG. 5. Other methods of providing desiccant protection in a tape and real IC shipping medium are also possible. The desiccant preforms can be affixed to the cover tape instead of the carrier tape. The semiconductor devices still receives equal protection from having a desiccant in close proximity to each device. It is possible that the desiccant itself can be formed as a film of hygroscopic material as opposed to the preform concept. The film desiccant can be affixed to the cover tape with an adhesive material; or in the case of a partially hydrolyzed polyvinyl alcohol desiccant, that material can act as its own adhesive. Furthermore, the methods of incorporating desiccants into an IC shipping medium can be applied to shipping media other than tape and reel, such as shipping rails or shipping trays.

The foregoing description and illustrations contained herein demonstrate the advantages associated with the present invention. In particular, it has been revealed that the invention is easily adaptable to fit varying IC shipping media, such as tape and reel, rails and trays. The desiccant can easily be manufactured to fit different sizes of carrier tape, rails and trays, either in strip, film or sheet form or as discrete preforms sized for the individual shipping compartments. Moreover, only minor modifications to existing designs of tape and reel, rails, and trays are required to incorporate the present invention into the packaging of ICs.

Thus it is apparent that there has been provided, in accordance with the invention, an individualized desiccant that fully meets the need and advantages set forth previously. Although the invention has been described and illustrated with reference to specific embodiments thereof, it is not intended that the invention be limited to these illustrative embodiments. For example, each of the IC shipping media disclosed is suited for carrying semiconductor devices of different configurations, in addition to the representative devices illustrated in the figures. Furthermore, a variation to the present invention can be a carrier tape coated with a desiccating material, such as polyvinyl alcohol. Then during the elevated temperature sealing of the carrier tape with a cover tape, the thermoplastic can act as the adhesive for the cover tape. Along the same line, trays can also be coated with a desiccant. Those skilled in the art will recognize that modifications and variations can be made without departing from the spirit of the invention. Therefore, it is intended that this invention encompass all such variations and modifications as fall within the scope of the appended claims.

## Claims

1. An integrated circuit (IC) shipping medium (10) comprising:
a shipping means (16) for carrying ICs (20), the shipping means having at least one compartment (18) wherein the ICs (20) are contained;
a retaining means (14) for containing the ICs (20) within the shipping means (16); and
a desiccant (12) placed in close proximity to the ICs (20) contained inside the compartment (18) of the shipping means (16) wherein the desiccant (12) is individualized for each of the ICs (20).

2. The IC shipping medium (10) according to claim 1 wherein the desiccant (12) comprises a continuous layer of desiccant located between the shipping means (16) and the retaining means (14).

3. An IC shipping medium (10) comprising:
a carrier tape (16) having a plurality of compartments (18) in series for carrying ICs (20), the carrier tape (16) extending for at least a first length;
a cover tape (14) for sealing the ICs (20) inside the carrier tape (16), the cover tape (14) extending for at least the first length; and
a layer of desiccant (12) wherein the layer extends for at least the first length and is placed in close proximity to the ICs (20) contained inside the carrier tape (16).

4. The IC shipping medium (10) according to claim 3 wherein the layer of desiccant (12) further comprises a continuous layer of desiccant located between the carrier tape (16) and the cover tape (14), the continuous layer being substantially in a range of 0.05 millimeter to 0.64 millimeter.

5. The IC shipping medium (26) according to claim 3 wherein the layer of desiccant further comprises a plurality of individualized desiccants (28) located in the plurality of compartments (18) of the carrier tape (16).

6. The IC shipping medium (10) according to claim 3 wherein the layer of desiccant (12) is comprised of a material selected from the group consisting of: a polyvinyl alcohol, a polyvinyl ethylene acetate copolymer, a methyl cellulose, a water soluble polymer, a silica gel, and a polyimide.

7. An IC shipping medium (40) comprising:
a shipping means (16) for carrying ICs (20), the shipping means (16) having at least one compartment (18) wherein the ICs (20) are contained;
a retaining means (14) for containing the ICs (20) within the shipping means (16);
a desiccant (28) placed in close proximity to the ICs (20) contained inside the compartment (18) of the shipping means (16) wherein the desiccant (28) is individualized for each of the ICs (20); and
a plurality of humidity sensing indicators (44, 46 & 48) placed in close proximity to the ICs (20) contained inside the compartment (18) of the shipping means (16), the plurality of humidity sensing indicators (44, 46 & 48) being located between the shipping means (16) and the retaining means (14), the plurality of humidity sensing indicators (44, 46 & 48) comprising a continuous strip (42) with a repeating series of humidity indicators (44, 46 & 48), wherein each of the plurality of humidity sensing indicators (44, 46 & 48) monitors a small groups of the ICs (20).

8. The IC shipping medium according to claim 1 or claim 7 wherein the shipping means for carrying ICs comprises a shipping medium selected from a group consisting of: a tape and reel, a shipping rail, and a shipping tray.

9. The IC shipping medium according to claim 1 or claim 7 wherein the desiccant is comprised of a material selected from the group consisting of: a polyvinyl alcohol, a polyvinyl ethylene acetate copolymer, a methyl cellulose, a water soluble polymer, a silica gel, and a polyimide.

10. The IC shipping medium according to claim 1 or claim 7 wherein the desiccant comprises a sheet of desiccant sized to cover the ICs contained within the shipping means, the sheet of desiccant being located between the shipping means and the retaining means.
